# EUROPEAN PATENT APPLICATION

(11) **EP 4 576 171 A1**
(43) Date of publication of application: **25.06.2025**
(21) Application number: 24195819.8
(22) Date of filing: 22.08.2024
(51) Int. Cl.: H01L 21/283, H01L 21/768, H01L 23/48, H01L 23/528, H10D 84/01

(54) **SEMICONDUCTOR DEVICE INCLUDING A FIELD EFFECT TRANSISTOR AND METHOD OF MANUFACTURING THE SAME**

(30) Priority: 19.12.2023 KR 20230186023
(71) Applicant: Samsung Electronics Co., Ltd, Suwon-si, Gyeonggi-do 16677 (KR)
(72) Inventor: CHAE, Myeonggyoon, 16677 Suwon-si (KR); LEE, Kyoungwoo, 16677 Suwon-si (KR); HA, Seungseok, 16677 Suwon-si (KR); KIM, Youngwoo, 16677 Suwon-si (KR); KIM, Junsoo, 16677 Suwon-si (KR); LEE, Minseung, 16677 Suwon-si (KR); CHOI, Shinkyu, 16677 Suwon-si (KR)
(74) Representative: Marks & Clerk LLP

(57) **Abstract**

A semiconductor device includes: a substate; a power distribution network layer disposed on a lower surface of the substrate; a source/drain pattern disposed on the substrate; a backside conductive structure configured to penetrate the substrate and to electrically connect the source/drain pattern and the power distribution network layer to each other; and a remaining pattern covering a side surface of an upper portion of the backside conductive structure.

## Description

### TECHNICAL FIELD

Embodiments of the present inventive concept relate to a semiconductor device and a method of manufacturing the same, and more particularly, to a semiconductor device including a field effect transistor and a method of manufacturing the same.

### DISCUSSION OF THE RELATED ART

Generally, a semiconductor device may include an integrated circuit including metal-oxide-semiconductor field effect transistors (MOSFETs). As sizes and design rules of semiconductor devices have been reduced, sizes of MOSFETs have also been scaled down. Operating characteristics of semiconductor devices may be deteriorated by the scale down of the MOSFETs. Thus, semiconductor devices capable of overcoming limitations caused by a high integration density and having increased performance has been under development.

### SUMMARY

According to embodiments of the present inventive concept, a semiconductor device includes: a substate; a power distribution network layer disposed on a lower surface of the substrate; a source/drain pattern disposed on the substrate; a backside conductive structure configured to penetrate the substrate and to electrically connect the source/drain pattern and the power distribution network layer to each other; and a remaining pattern covering a side surface of an upper portion of the backside conductive structure.

According to embodiments of the present inventive concept, a semiconductor device includes: a substrate: a power distribution network layer disposed on a lower surface of the substrate; a source/drain pattern disposed on the substrate; a backside conductive structure penetrating the substrate and electrically connecting the source/drain pattern and the power distribution network layer to each other; and a remaining pattern disposed on a side surface of the backside conductive structure, wherein the backside conductive structure has a step at the first level, and wherein a lower surface of the remaining pattern is positioned at a level substantially the same as or lower than the first level.

According to embodiments of the present inventive concept, a semiconductor device includes: a substrate: a power distribution network layer disposed on a lower surface of the substrate; an insulating pattern disposed on the substrate; a source/drain pattern disposed on the insulating pattern; a channel pattern disposed on a side surface of the source/drain pattern, and including a plurality of semiconductor patterns stacked and spaced apart from each other; a gate electrode disposed between the plurality of semiconductor patterns; a backside conductive structure penetrating the substrate and electrically connecting the source/drain pattern and the power distribution network layer to each other; and a remaining pattern disposed on a side surface of the backside conductive structure, wherein the backside conductive structure has a step at the first level, and wherein a lower surface of the remaining pattern is positioned at a level substantially the same as or lower than the first level.

At least some of the above and other features of the invention are set out in the claims.

### BRIEF DESCRIPTION OF THE DRAWINGS

The above and other aspects of the present inventive concept will become more apparent by describing in detail embodiments thereof, with reference to the accompanying drawings, in which:
FIG. 1 is a plan view showing a semiconductor device according to embodiments of the present inventive concept.
FIGS. 2A, 2B, 2C, and 2D are cross-sectional views corresponding to lines A-A', B-B', C-C', and D-D' of FIG. 1, respectively.
FIG. 3 is a cross-sectional view showing a semiconductor device according to embodiments of the present inventive concept.
FIGS. 4A, 4B, 5A, 5B, 6A, 6B, 6C, 7A, 7B, 8, 9A, 9B, 9C, 10A, 10B, and 10C are views showing a method of manufacturing a semiconductor device according to embodiments of the present inventive concept.

### DETAILED DESCRIPTION OF THE EMBODIMENTS

Hereinafter, embodiments of the present inventive concept will be described with reference to the accompanying drawings.

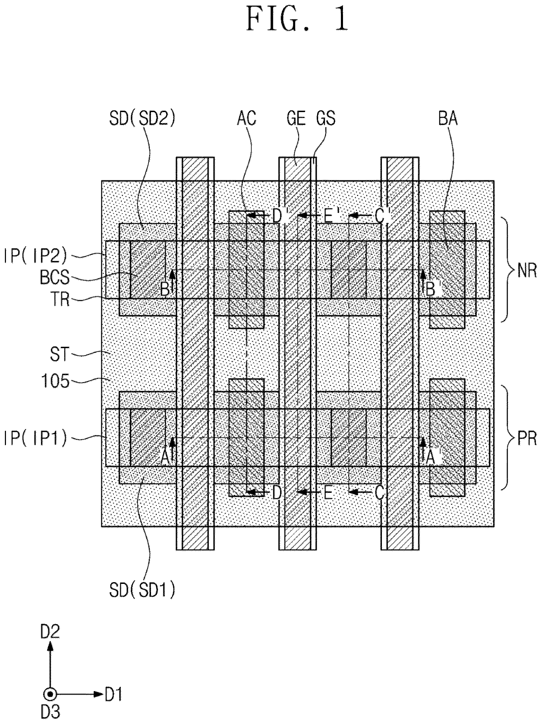

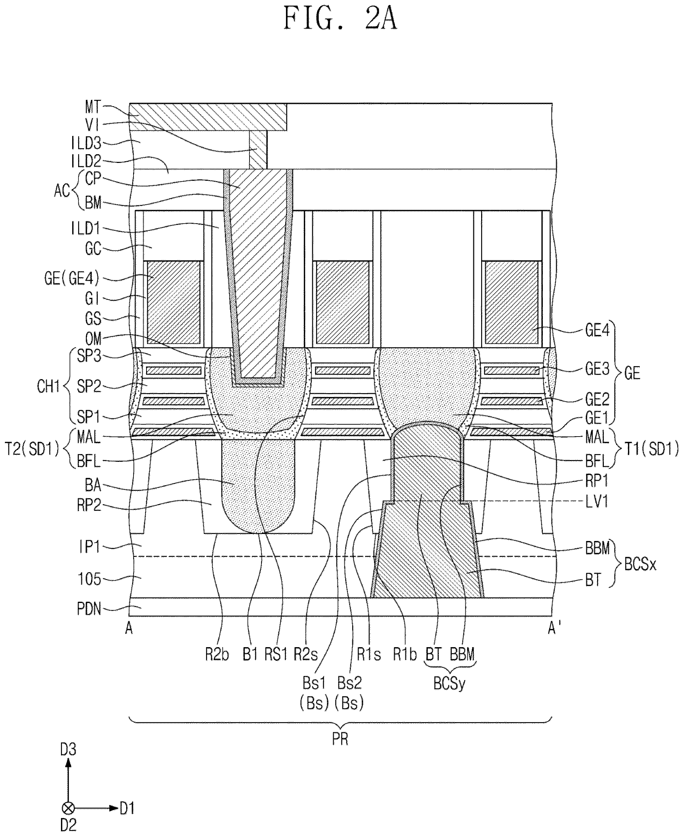

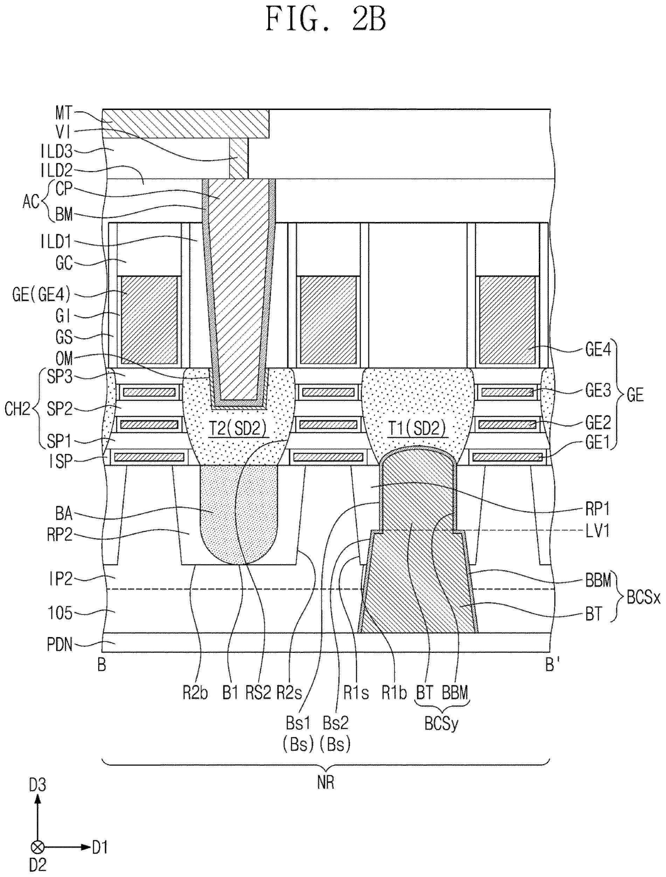

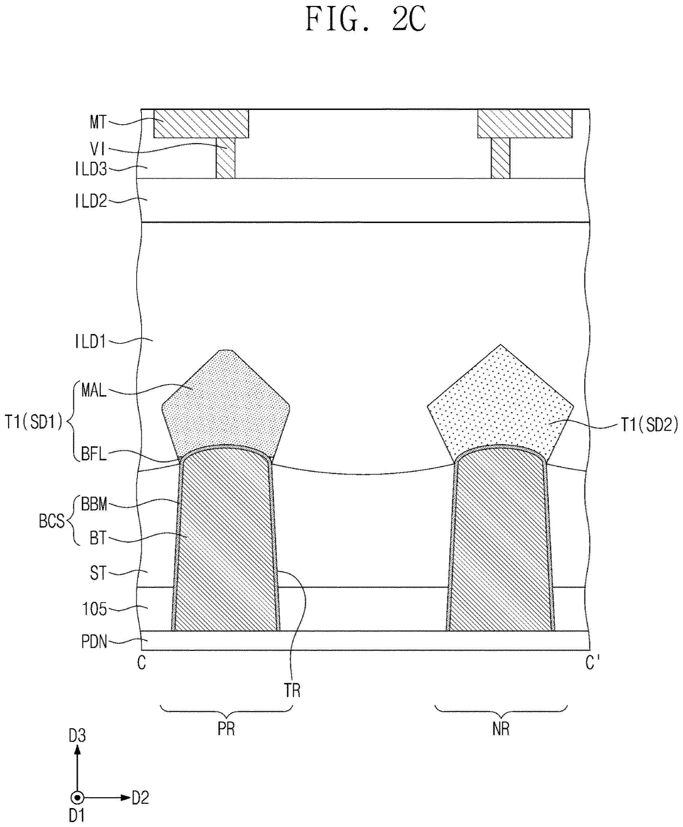

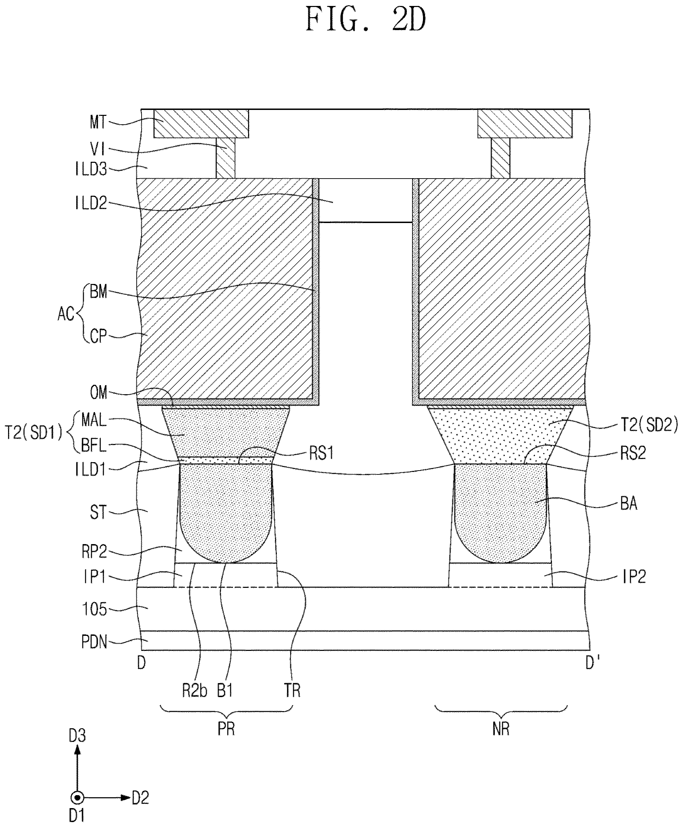

FIG. 1 is a plan view showing a semiconductor device according to embodiments of the present inventive concept. FIGS. 2A to 2D are cross-sectional views corresponding to lines A-A', B-B', C-C', and D-D' of FIG. 1, respectively.

Referring to FIGS. 1 and 2A to 2D, a substrate 105 including a PMOS region PR and an NMOS region NR may be provided. As an example, the substrate 105 may include a silicon-based insulating layer. For example, the substrate 105 may be an insulating substrate. As an example, the substrate 105 may include at least one of a silicon oxide layer (SiO₂), a silicon nitride layer (SiN), and/or a silicon oxynitride layer (SiON). As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases.

The PMOSFET region PR and the NMOSFET region NR may each extend in a first direction D1 and be spaced apart from each other in a second direction D2. The first and second directions D 1 and D2 may be parallel to a lower surface of the substrate 105 and may intersect (e.g., be perpendicular to) each other. The lower surface of the substrate 105 may be a surface upon which a power distribution network layer PDN is located. As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

Insulating patterns IP1 and IP2 may be defined by the formation of a trench TR in an upper portion of the substrate 105. The insulating patterns IP1 and IP2 may be a portion of the substrate 105. For example, the portion of the substrate 105 may protrude in a third direction D3. The third direction D3 may be a direction that is perpendicular to the lower surface of the substrate 105. For convenience of explanation, unless otherwise specified, in this specification, the substrate 105 is defined to refer to a portion other than the above portion (that is, the insulating patterns IP1 and IP2) of the substrate 105. The insulating patterns IP1 and IP2 may include a first insulating pattern IP1 provided on the PMOSFET region PR and a second insulating pattern IP2 provided on the NMOSFET region NR. The first and second insulating patterns IP1 and IP2 may extend in the first direction D1. Relative height positions (e.g. above, below, upper, lower, etc.) may be defined based on the third direction D3, which may be a vertical, or height, direction. It will be appreciated that the directions defined herein are relative to the structure of the semiconductor device, and need not indicate any particular orientation of the semiconductor device in use.

A device isolation pattern ST may be provided on the substrate 105 and fill the trench TR. The device isolation pattern ST may at least partially surround the first and second insulating patterns IP1 and IP2. The device isolation pattern ST may include an insulating material. As an example, the device isolation pattern ST may include silicon oxide (SiO₂).

A first channel pattern CH1 may be provided on the first insulating pattern IP1, and a second channel pattern CH2 may be provided on the second insulating pattern IP2. A plurality of first channel patterns CH1 may be provided and may be spaced apart from each other in the first direction D1. A plurality of second channel patterns CH2 may be provided and may be spaced apart from each other in the first direction D1. Each of the first and second channel patterns CH1 and CH2 may include a first semiconductor pattern SP1, a second semiconductor pattern SP2, and a third semiconductor pattern SP3 adjacent to each other in the third direction D3, but the present inventive concept is not limited thereto. As an example, each of the first and second channel patterns CH1 and CH2 may include four or more semiconductor patterns. As an example, each of the first to third semiconductor patterns SP1, SP2, and SP3 may include crystalline silicon.

First recesses RS1 may be defined between first channel patterns CH1 that are adjacent to each other in the first direction D1. Second recesses RS2 may be defined between second channel patterns CH2 that are adjacent to each other in the first direction D1.

First source/drain patterns SD1 may be provided on the first insulating pattern IP1, and second source/drain patterns SD2 may be provided on the second insulating pattern IP2. The first source/drain patterns SD1 may fill the first recesses RS1, and the second source/drain patterns SD2 may fill the second recesses RS2. Each of the first and second source/drain patterns SD1 and SD2 may be electrically connected to adjacent first to third semiconductor patterns SP1, SP2, and SP3. The first source/drain patterns SD1 may be impurity regions of a first conductivity type (e.g., p-type), and the second source/drain patterns SD2 may be impurity regions of a second conductivity type (e.g., n-type) impurity regions. As an example, a pair of first source/drain patterns SD1 may be electrically connected to each other through the first channel pattern CH1. As an example, a pair of second source/drain patterns SD2 may be electrically connected to each other through the second channel pattern CH2.

The first source/drain patterns SD1 may include a semiconductor element (e.g., SiGe) having a lattice constant greater than a lattice constant of the semiconductor element of the first channel pattern CH1. Accordingly, the pair of first source/drain patterns SD1 may provide compressive stress to the first channel pattern CH1 therebetween. The second source/drain patterns SD2 may include the same semiconductor element (e.g., Si) as the second channel pattern CH2.

The first source/drain pattern SD1 may include a buffer layer BFL and a main layer MAL. The buffer layer BFL covers an inner surface of the first recess RS1, and the main layer MAL fills most of the remaining region of the first recess RS1 that is not filled by the buffer layer BFL. As an example, each of the buffer layer BFL and main layer MAL may include silicon-germanium (SiGe). The buffer layer BFL may include a relatively low concentration of germanium (Ge). The main layer MAL may include a relatively high concentration of germanium (Ge) (e.g. relative to the buffer layer BFL). As another example, the buffer layer BFL may include only silicon (Si).

The first source/drain patterns SD1 and the second source/drain patterns SD2 may include a first pattern T1 and a second pattern T2. The first pattern T1 is electrically connected to a power distribution network layer PDN to be described later, and the second pattern T2 is electrically connected to an active contact AC to be described later.

A gate electrode GE may be provided on the first and second channel patterns CH1 and CH2 and may cross the first and second channel patterns CH1 and CH2. A plurality of gate electrodes GE may be provided. The gate electrodes GE may each extend in the second direction D2 and be spaced apart from each other in the first direction D1.

The gate electrode GE may include an inner electrode and an outer electrode. The inner electrode of the gate electrode GE may be provided between the uppermost semiconductor pattern among a plurality of semiconductor patterns SP1, SP2, and SP3 and the insulating patterns IP1 and IP2. The outer electrode of the gate electrode GE may be provided on the uppermost semiconductor pattern. For example, the inner electrode of the gate electrode GE may include a first electrode portion GE1, a second electrode portion GE2, and a third electrode portion GE3, but the present inventive concept is not limited thereto. For example, the inner electrode of the gate electrode GE may include four or more electrode portions. For example, the first electrode portion GE1 may be interposed between the insulating patterns IP1 and IP2 and the first semiconductor pattern SP1. The second electrode portion GE2 may be interposed between the first semiconductor pattern SP1 and the second semiconductor pattern SP2. The third electrode portion GE3 may be interposed between the second semiconductor pattern SP2 and the third semiconductor pattern SP3. For example, the outer electrode of the gate electrode GE may include a fourth electrode portion GE4. For example, the fourth electrode portion GE4 may be provided on the third semiconductor pattern SP3.

The gate electrode GE may include a first metal pattern and a second metal pattern disposed on the first metal pattern. The first metal pattern may include a work function metal that adjusts the threshold voltage of the transistor. As an example, the first metal pattern may include at least one of a metal material (e.g., Ti, Mo, W, Cu, Al, Ta, Ru, Ir, Co, etc.) and/or a metal nitride (e.g., nitride of a metal such as Ti, Mo, W, Cu, Al, Ta, Ru, Ir, and Co). As an example, the first metal pattern may further include carbon (C). As an example, the first metal pattern may include metal materials having different work functions from each other.

As an example, the second metal pattern may include a metal material (e.g., Ti, Mo, W, Cu, Al, Ta, Ru, Ir, Co, etc.) with lower resistance than that of the first metal pattern.

As an example, the first to third electrode portions GE1, GE2, and GE3 of the gate electrode GE may include a first metal pattern. For example, the fourth electrode portion GE4 of the gate electrode GE may include a first metal pattern and a second metal pattern.

A gate capping pattern GC may be provided on an upper surface of the gate electrode GE. As an example, the gate capping pattern GC may include at least one of SiON, SiCN, SiOCN, and/or SiN.

Gate spacers GS may be provided on side surfaces of the fourth electrode portion GE4 of the gate electrode GE and may extend onto side surfaces of the gate capping pattern GC, respectively. The gate spacer GS may include a single layer or a composite layer. As an example, the gate spacer GS may include at least one of SiON, SiCN, SiOCN, and/or SiN.

A gate insulating pattern GI may be interposed between the gate electrode GE and the first to third semiconductor patterns SP1, SP2, and SP3. The gate insulating pattern GI may cover an upper surface, a lower surface, and both side surfaces of each of the first to third semiconductor patterns SP1, SP2, and SP3. The gate insulation pattern GI may cover an upper surface of the isolation pattern ST below the gate electrode GE. The gate insulating pattern GI may be interposed between the fourth electrode portion GE4 and the gate spacer GS. As an example, the gate insulation pattern GI may include at least one of silicon oxide (SiO₂), silicon oxynitride (SiON), and/or a high dielectric material. In this specification, a high dielectric material is defined as a material that has a higher dielectric constant than that of silicon oxide.

An inner spacer ISP may be interposed between side surfaces of the second source/drain pattern SD2 and the gate electrode GE. As an example, the inner spacer ISP may be interposed between the inner electrode and the second source/drain pattern SD2. As an example, the inner spacer ISP may include an insulating material.

A first interlayer insulating layer ILD1 may be provided on the substrate 105. The first interlayer insulating layer ILD1 may cover the gate spacers GS and the first and second source/drain patterns SD1 and SD2. An upper surface of the first interlayer insulating layer ILD1 may be positioned at substantially the same level as an upper surface of the gate capping pattern GC and an upper surface of the gate spacer GS.

A second interlayer insulating layer ILD2 may cover the gate capping pattern GC and may be disposed on the first interlayer insulating layer ILD1. A third interlayer insulating layer ILD3 may be provided on the second interlayer insulating layer ILD2. As an example, the first to third interlayer insulating layers ILD1, ILD2, and ILD3 may each include silicon oxide (SiO₂).

An active contact AC may penetrate the first and second interlayer insulating layers II,D1 and ILD2 in the third direction D3. A plurality of active contacts AC may be provided, and a lower portion of each of the active contacts AC may be disposed in an upper portion of the second pattern T2 of the source/drain patterns SD1 and SD2.

The active contact AC may include a conductive pattern CP and a barrier pattern BM. The conductive pattern CP penetrates the first and second interlayer insulating layers ILD1 and ILD2, and the barrier pattern BM at least partially surrounds the conductive pattern CP. As an example, the conductive pattern CP may include a metal material (e.g., Ti, Mo, W, Cu, Al, Ta, Ru, Ir, Co, etc.). As an example, the barrier pattern BM may include metal nitride (e.g., nitride of a metal such as Ti, Mo, W, Cu, Al, Ta, Ru, Ir, Co, etc.).

An ohmic pattern OM may be interposed between the active contact AC and the second pattern T2 of the source/drain patterns SD1 and SD2. Accordingly, a contact resistance between the active contact AC and the second pattern T2 of the source/drain patterns SD1 and SD2 may be improved (e.g. reduced). As an example, the ohmic pattern OM may include metal silicide (e.g., silicide of a metal such as Ti, Mo, W, Cu, Al, Ta, Ru, Ir, etc.).

Metal patterns MT may be provided in the third interlayer insulating layer ILD3. Vias VI may be interposed between the metal patterns MT and the active contacts AC. The metal patterns MT may be electrically connected to the active contacts AC through the vias VI. As an example, gate contacts may be connected to the gate electrodes GE, and metal patterns MT may be electrically connected to the gate contacts through vias VI. As an example, each of the metal patterns MT and vias VI may be provided in multiple layers, and the metal patterns MT and the vias VI may be alternately stacked on each other. The metal patterns MT and vias VI may include a metal material (e.g., Ti, Mo, W, Cu, Al, Ta, Ru, Ir, Co, etc.).

A power distribution network layer PDN may be provided on a lower surface of the substrate 105. The power distribution network layer PDN may include a plurality of lower wirings electrically connected to the source/drain patterns SD1 and SD2 through a backside conductive structure BCS, which will be described later. As an example, the power distribution network layer PDN may include a wiring network for applying a source voltage. As an example, the power distribution network layer PDN may include a wiring network for applying a drain voltage.

A backside conductive structure BCS may be provided in the substrate 105. The backside conductive structure BCS may penetrate the substrate 105 and may be interposed between the first pattern T1 of the source/drain patterns SD1 and SD2 and the power distribution network layer PDN. The backside conductive structure BCS may electrically connect the first pattern T1 of the source/drain patterns SD1 and SD2 and the power distribution network layer PDN to each other.

The backside conductive structure BCS may have a step at a first level LV1. For example, a side surface Bs of the backside conductive structure BCS may have a step at the first level LV1. The side surface Bs may be a surface facing the first direction D1 or a direction opposite to the first direction D1. Due to the step, the backside conductive structure BCS may have a first side surface Bs1 and a second side surface Bs2. The first side surface Bs1 may be at a level higher than the first level LV1, and the second side surface Bs2 may be at a level lower than the first level LV1.

The backside conductive structure BCS may include an upper portion BCSy and a lower portion BCSx that do not have an interface at the first level LV1 with each other. The upper portion BCSy may be a portion of the backside conductive structure BCS that is above the first level LV1. The lower portion BCSx may be a portion of the backside conductive structure BCS that is below the first level LV1. The upper portion BCSy and lower portion BCSx may be integrally formed (e.g. there may not be any interface between the upper portion BCSy and the lower portion BCSx). The first side surface Bs1 of the backside conductive structure BCS may be a side surface Bs1 of the upper portion BCSy of the backside conductive structure BCS, and the second side surface Bs2 may be a side surface Bs2 of the lower portion BCSx of the backside conductive structure BCS. With respect to the first direction D1, a width of the upper portion BCSy of the backside conductive structure BCS at the first level LV1 may be smaller than a width of the lower portion BCSx of the backside conductive structure BCS at the first level LV1, but the present inventive concept is not limited thereto.

The backside conductive structure BCS may include a backside conductive pattern BT and a back barrier pattern BBM surrounding the backside conductive pattern BT. As an example, the backside conductive pattern BT may include a metal material (e.g., Ti, Mo, W, Cu, Al, Ta, Ru, Ir, Co, etc.). As an example, the back barrier pattern BBM may include metal nitride (e.g., nitride of a metal such as Ti, Mo, W, Cu, Al, Ta, Ru, Ir, Co, etc.).

A backside alignment pattern BA may be provided on the substrate 105 and may be embedded in the insulating patterns IP1 and IP2. The backside alignment pattern BA may be provided below the second pattern T2 of the source/drain patterns SD1 and SD2. The second pattern T2 of the source/drain patterns SD1 and SD2 may vertically overlap and/or may be in contact with the backside alignment pattern BA. As an example, the backside alignment pattern BA may include silicon-germanium (SiGe). The backside alignment pattern BA may be spaced apart from the power distribution network layer PDN by the substrate 105.

A remaining pattern RP may be provided on the substrate 105. The remaining pattern RP may be provided in the insulating patterns IP1 and IP2. A plurality of remaining patterns RP may be provided, and the remaining patterns RP may be adjacent to each other in the first direction D1 in the insulating patterns IP1 and IP2 that extend in the first direction D1. The remaining pattern RP may include a semiconductor material. As an example, the remaining pattern RP may include silicon (Si).

The remaining pattern RP may include a first remaining pattern RP1 and a second remaining pattern RP2. The first remaining pattern RP1 may be disposed on the side surface Bs of the backside conductive structure BCS, and the second remaining pattern RP2 may be disposed on the side surface of the backside alignment pattern BA.

The first remaining pattern RP1 may cover the side surface Bs1 of the upper portion BCSy of the backside conductive structure BCS. As an example, the first remaining pattern RP1 may completely cover the side surface Bs1 of the upper portion BCSy of the backside conductive structure BCS. Accordingly, the upper portion BCSy of the backside conductive structure BCS may be spaced apart from the insulating patterns IP1 and IP2 by the first remaining pattern RP1. The first remaining pattern RP1 may cover a portion of the side surface Bs2 of the lower portion BCSx of the backside conductive structure BCS. As above described, as the first remaining pattern RP1 covers the side surface Bs of the backside conductive structure BCS, a side surface of the remaining pattern RP1 that is in contact with the backside conductive structure BCS may have a step.

A lower surface R1b of the first remaining pattern RP1 may be positioned at a level lower than the first level LV1. The lower surface R1b of the first remaining pattern RP1 may extend in the first direction D1 or a direction opposite to the first direction D1 on the side surface Bs of the backside conductive structure BCS. For example, the first remaining pattern RP1 may have a width in the first direction D1 or in a direction opposite to the first direction D1. For example, the level of the lower surface R1b of the first remaining pattern RP1 may be substantially constant (e.g. flat, such as parallel to the first and second directions D1 and D2).

The first remaining pattern RP1 may have a side surface R1s opposing the side surface Bs of the backside conductive structure BCS. A side surface R1s of the first remaining pattern RP1 may be spaced apart from the side surface Bs of the backside conductive structure BCS. The side surface R1s and the lower surface R1b of the first remaining pattern RP1 may meet at an angle. For example, the side surface R1s and the lower surface R1b of the first remaining pattern RP1 may meet to form an angle of 90 degrees or more (e.g. an angle greater than or equal to 90 degrees and less than 180 degrees). For example, the side surface R1s of the first remaining pattern RP1 may have a profile inclined in a direction away from the backside conductive structure BCS.

A plurality of first remaining patterns RP1 may be provided. The first remaining patterns RP1, which are adjacent to each other in the first direction D1, may be provided on both side surfaces Bs of a corresponding backside conductive structure BCS.

The second remaining pattern RP2 may surround and cover the backside alignment pattern BA. The backside alignment pattern BA may be spaced apart from the insulating patterns IP1 and IP2 by the second remaining pattern RP2. A lower surface R2b of the second remaining pattern RP2 may be positioned at substantially the same level as a lower surface B1 of the backside alignment pattern BA, or may be positioned at a lower level.

A profile of a side surface R2s of the second remaining pattern RP2 and an angle between the side surface R2s and the lower surface R2b may be the same/similar to those described with reference to the first remaining pattern RP1.

The first remaining pattern RP1 and the second remaining pattern RP2 may be spaced apart from each other. Accordingly, the first remaining pattern RP1 and the second remaining pattern RP2 might not be electrically connected to each other. As a result, unnecessary leakage current might not flow from the first remaining pattern RP1 to the second remaining pattern RP2 or from the second remaining pattern RP2 to the first remaining pattern RP1. Accordingly, reliability of the semiconductor device may be increased.

A distance between the first remaining pattern RP1 and the second remaining pattern RP2 may decrease as the first remaining pattern RP1 and the second remaining pattern RP2 extend in the third direction D3 (e.g. away from the lower surface of the substrate 105). The side surfaces R1s and R2s of the first and second remaining patterns RP1 and RP2 may vertically overlap the gate electrode GE (e.g. the side surfaces R1s and R2s may be located below the gate electrode GE). The side surfaces R1s and R2s of the first and second remaining patterns RP1 and RP2 may extend together in a direction in which the gate electrode GE extends. A portion of the insulating patterns IP1 and IP2 may protrude in the third direction D3 due to the first remaining pattern RP1 and the second remaining pattern RP2. A width of the portion of the insulating patterns IP1 and IP2 in the first direction D1 may decrease toward the third direction D3.

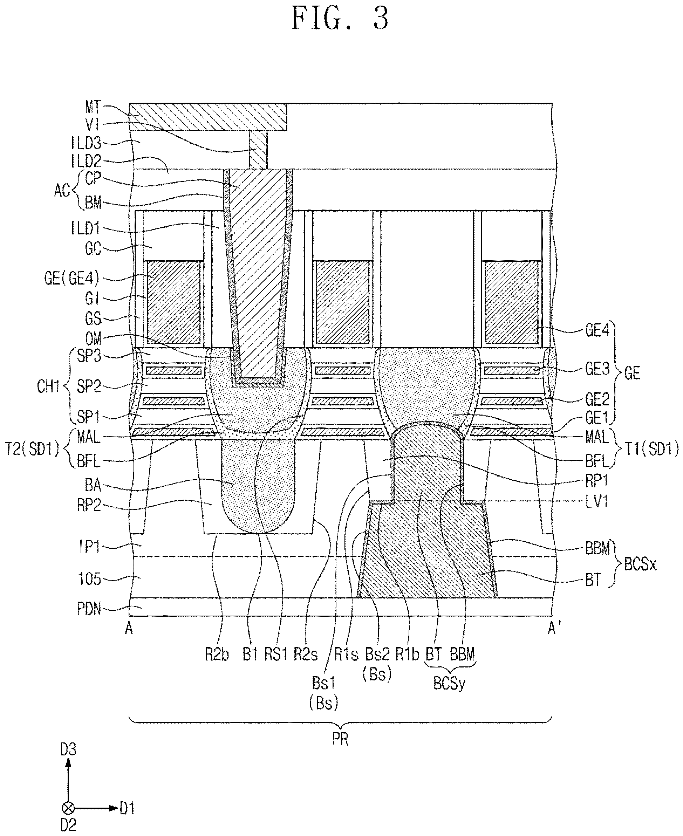

Hereinafter, semiconductor devices according to embodiments of the present inventive concept will be described with reference to FIG. 3. To simplify the explanation, description of content that overlaps with the above-described content will be omitted, and the explanation will focus on the differences from the above-described content.

FIG. 3 is a cross-sectional view showing a semiconductor device according to embodiments of the present inventive concept.

Referring to FIG. 3, in the first direction D1, a width of the lower portion BCSx of the backside conductive structure BCS at the first level LV1 may be larger than the width of the lower portion BCSx of the backside conductive structure BCS at the first level LV1 that is described with reference to FIG. 2A. The lower portion BCSx of the backside conductive structure BCS at the first level LV1 may extend to meet the side surfaces R1s of the first and second insulating patterns IP1 and IP2. Accordingly, the lower surface of the first remaining pattern RP1 may be positioned at substantially the same level as the first level LV1.

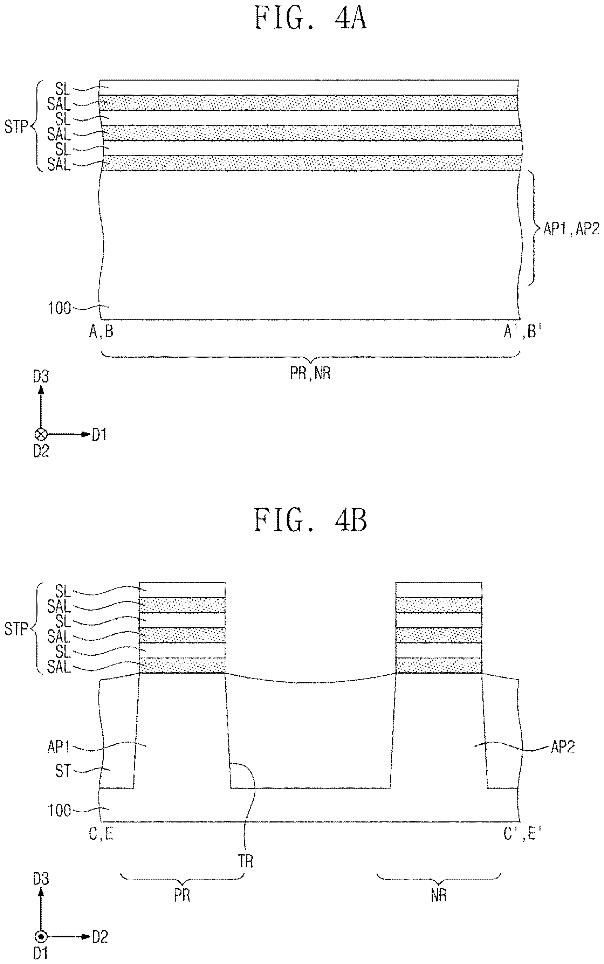

FIGS. 4A to 10C are views showing a method of manufacturing a semiconductor device according to embodiments of the present inventive concept.

Referring to FIGS. 1, 4A, and 4B, a semiconductor substrate 100 including a PMOSFET region PR and a NMOSFET region NR may be provided. For example, the semiconductor substrate 100 may be a semiconductor substrate including a semiconductor material, such as a silicon single crystal substrate, a silicon-germanium substrate, or an SOI substrate. Stacked patterns STP may be formed on the PMOSFET region PR and the NMOSFET region NR. For example, forming the stacked patterns STP may include alternately stacking semiconductor layers SL and sacrificial layers SAL on the semiconductor substrate 100, forming a mask patterns extending in the first direction D1, and performing a patterning process using the mask patterns as an etch mask. During the patterning process, a portion of the semiconductor substrate 100 may be removed, and trenches TR defining a first active pattern AP1 and a second active pattern AP2 may be formed.

The first active pattern AP1 may be formed on the PMOSFET region PR, and the second active pattern AP2 may be formed on the NMOSFET region NR. The first and second active patterns AP1 and AP2 may extend in the first direction D1. Device isolation patterns ST may be formed to fill the trenches TR.

The sacrificial layers SAL may include a material that has an etch selectivity with respect to the semiconductor layers SL. Accordingly, during the later-described removal process of the sacrificial layers SAL, even when the sacrificial layers SAL are removed, the semiconductor layers SL might not be removed or may be removed to a small extent. As an example, the semiconductor layers SL may include one of silicon (Si), germanium (Ge), or silicon-germanium (SiGe), and the sacrificial layers SAL may include one of silicon (Si), germanium (Ge), or silicon-germanium (SiGe) but is different from that of the semiconductor layers SL.

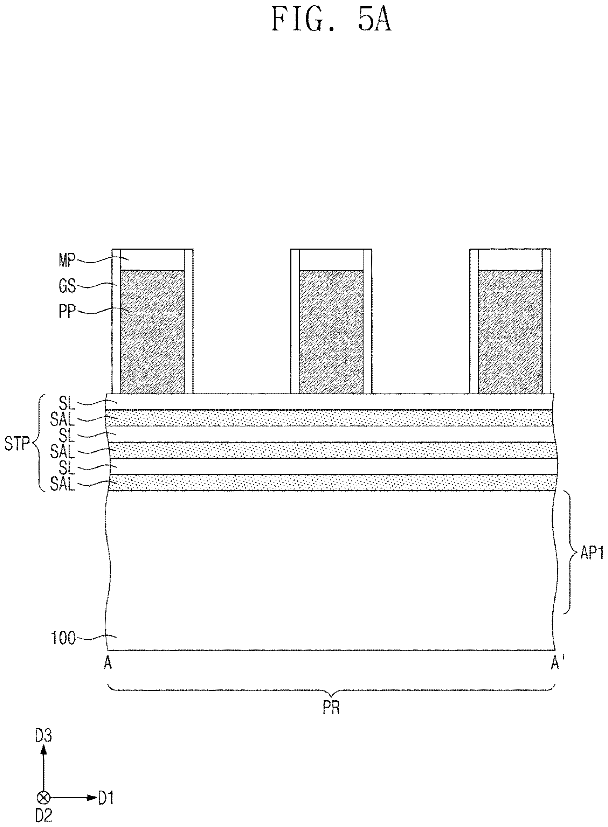

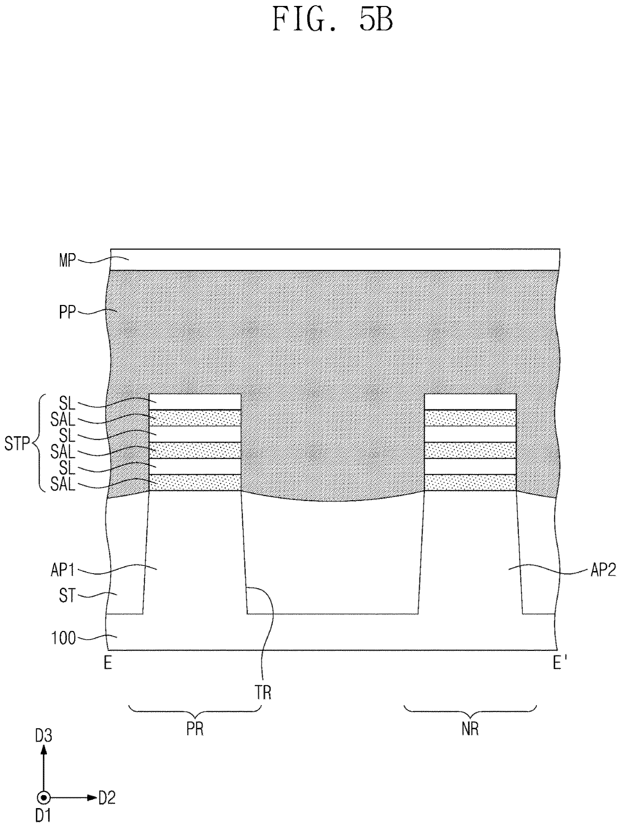

Referring to FIGS. 1, 5A, and 5B, sacrificial patterns PP may be formed to extend in the second direction D2, respectively, on the semiconductor substrate 100. The sacrificial patterns PP may be formed to cover upper surfaces of the isolation patterns ST and side surfaces and upper surfaces of the stacking patterns STP. For example, forming the sacrificial patterns PP may include forming a sacrificial layer on a front surface of the semiconductor substrate 100, forming hard mask patterns MP on the sacrificial layer, and removing a portion of the sacrificial layer using the hard mask patterns MP as an etch mask to form the sacrificial patterns PP. As an example, the sacrificial pattern PP may include polysilicon. Thereafter, gate spacers GS may be formed on side surfaces of the sacrificial patterns PP.

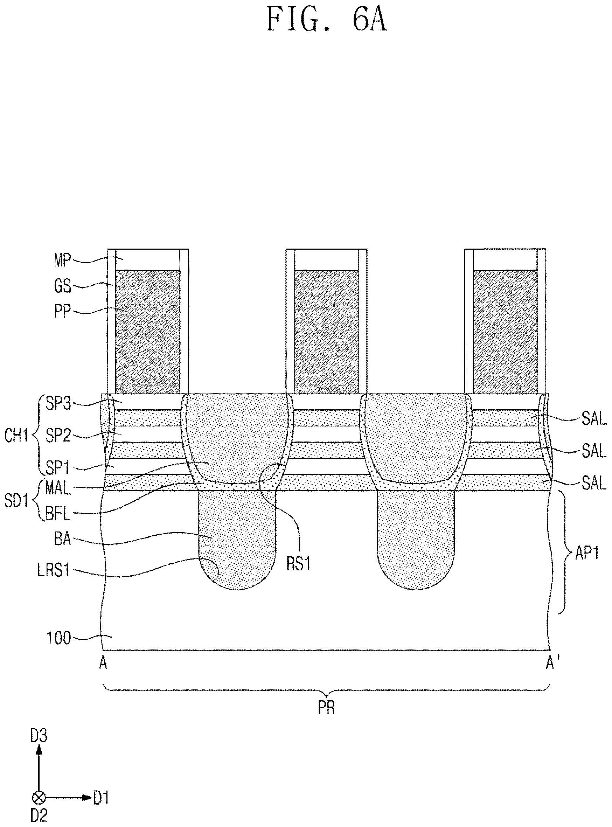

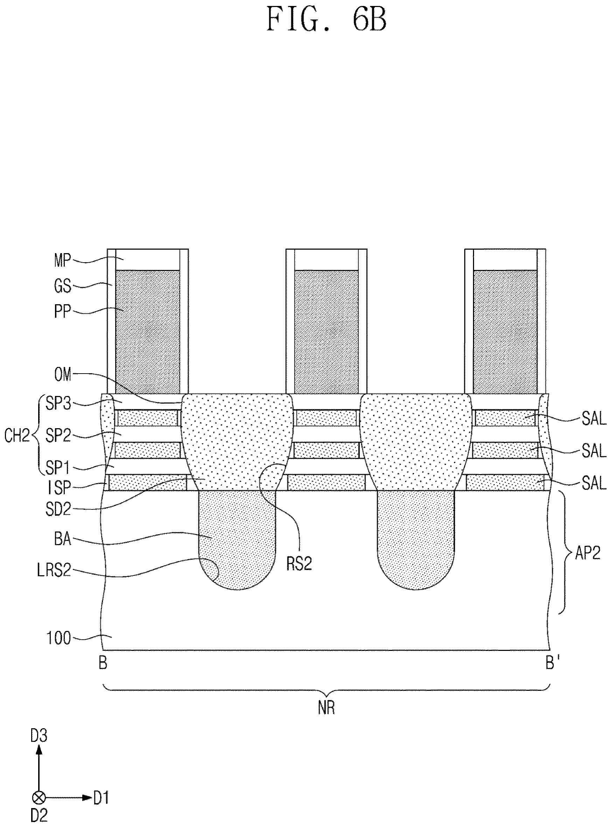

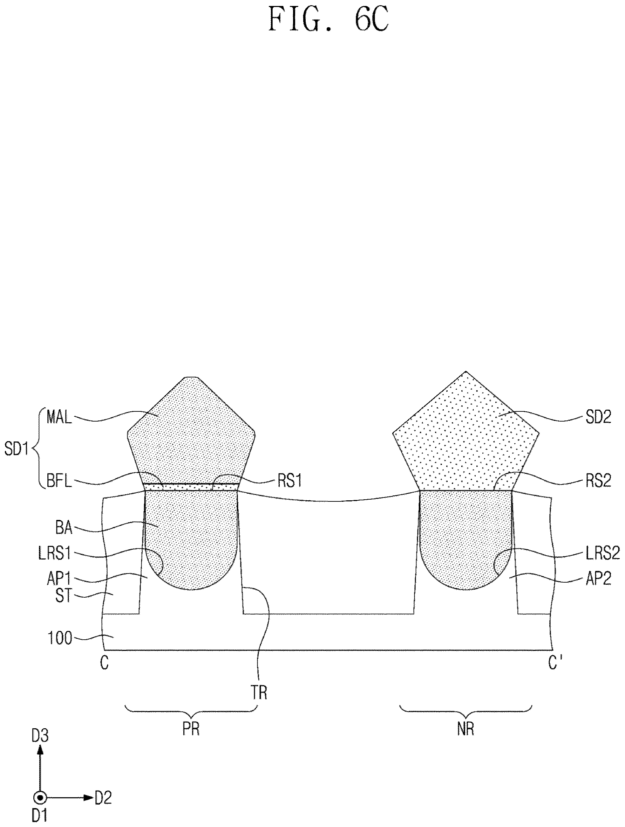

Referring to FIGS. 1 and 6A to 6C, first recesses RS1 may be formed in the stacked pattern STP on the first active pattern AP1. Second recesses RS2 may be formed in the stacked pattern STP on the second active pattern AP2. As an example, the first and second recesses RS1 and RS2 may be formed by removing a portion of the stacking pattern STP using the hard mask patterns MP as an etch mask.

The semiconductor layers SL, which are disposed on the first active pattern AP1 and may be separated by first recesses RS1, may be formed into first channel patterns CH1 that are spaced apart from each other in the first direction D1. The semiconductor layers SL, which are disposed on the second active pattern AP2 and may be separated by second recesses RS2, may be formed into second channel patterns CH2 that are spaced apart from each other in the first direction D1. Each of the first and second channel patterns CH1 and CH2 may include first to third semiconductor patterns SP1, SP2, and SP3.

A portion of the sacrificial layer SAL exposed by the second recess RS2 may be replaced with an insulating material, and accordingly, inner spacers ISP may be formed on both side surfaces of the sacrificial layer SAL.

A first lower recess LRS1 may be formed below the first recess RS1. A second lower recess LRS2 may be formed below the second recess RS2. A backside alignment pattern BA may be formed using the semiconductor substrate 100 as a seed to fill an interior of the lower recesses LRS1 and LRS2 through selective epitaxial growth (SEG).

First source/drain patterns SD1 may be formed in the first recesses RS1. The first source/drain patterns SD1 may be formed through SEG by using the first to third semiconductor patterns SP1, SP2, SP3 and the backside alignment patterns BA on the PMOSFET region PR as seeds.

For example, during forming the first source/drain pattern SD1, an impurity (e.g., boron, gallium, or indium) that causes p-type may be injected into the first source/drain pattern SD1 in-situ. As another example, after the first source/drain pattern SD1 is formed, impurities may be injected into the first source/drain pattern SD1.

Second source/drain patterns SD2 may be formed in the second recesses RS2. The second source/drain patterns SD2 may be formed through SEG using the first to third semiconductor patterns SP1, SP2, and SP3 and the backside alignment patterns BA on the NMOSFET region NR as seeds.

For example, during forming the second source/drain pattern SD2, an n-type impurity (e.g., phosphorus, arsenic, or antimony) that causes n-type may be injected into the second source/drain SD2 in-situ. As another example, after the second source/drain pattern SD2 is formed, impurities may be injected into the second source/drain pattern SD2.

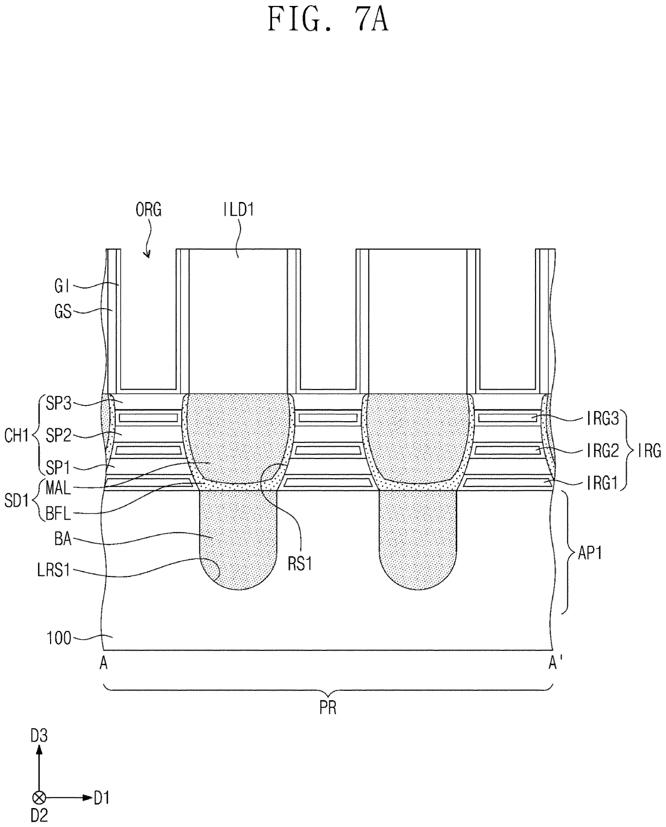

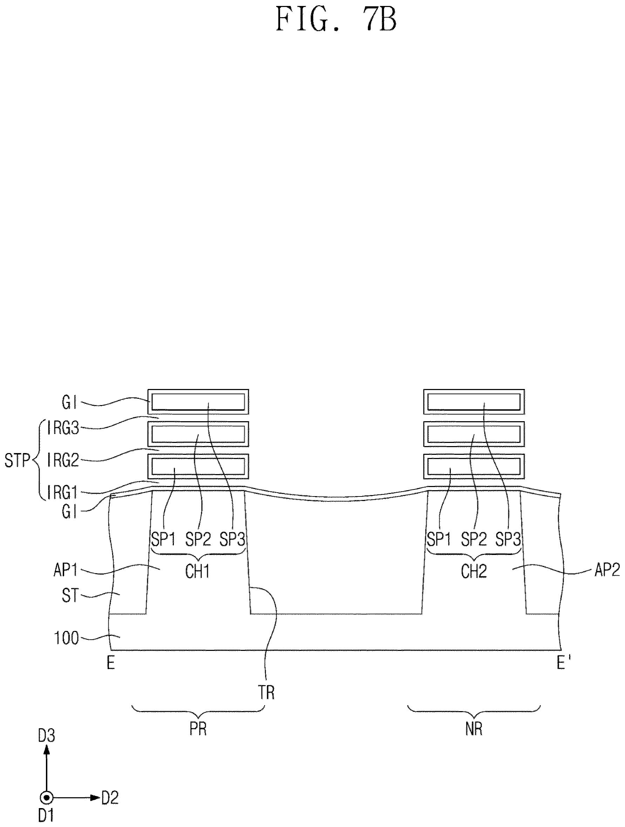

Referring to FIGS. 1, 7A, and 7B, the first interlayer insulating layer ILD1 may be formed to cover the first and second source/drain patterns SD1 and SD2, hard mask patterns MP, and gate spacers GS. Thereafter, the first interlayer insulating layer ILD that are disposed on upper surfaces of the sacrificial patterns PP may be removed. During the removal process, the hard mask patterns MP may also be removed, and the sacrificial patterns PP may be exposed.

Thereafter, the exposed sacrificial patterns PP may be removed, and an outer region ORG may be formed in the region from which the sacrificial patterns PP were removed. The first and second channel patterns CH1 and CH2 and the sacrificial layers SAL may be exposed to the outside by the outer region ORG.

Then, the exposed sacrificial layers SAL may be selectively removed. In this case, the first to third semiconductor patterns SP1, SP2, and SP3 might not be removed or may be removed to a small extent due to high etch selectivity of the sacrificial layers SAL.

Inner regions IRG may be formed in regions where the sacrificial layers SAL have been removed. For example, the inner regions IRG may be formed between the first to third semiconductor patterns SP1, SP2, and SP3. The inner regions IRG may include first to third inner regions IRG1, IRG2, and IRG3 that are spaced apart from each other in the third direction D3.

A gate insulating pattern GI may be formed in each of the inner regions IRG and the outer region ORG. The gate insulating pattern GI may be formed to surround each of the first to third semiconductor patterns SP1, SP2, and SP3.

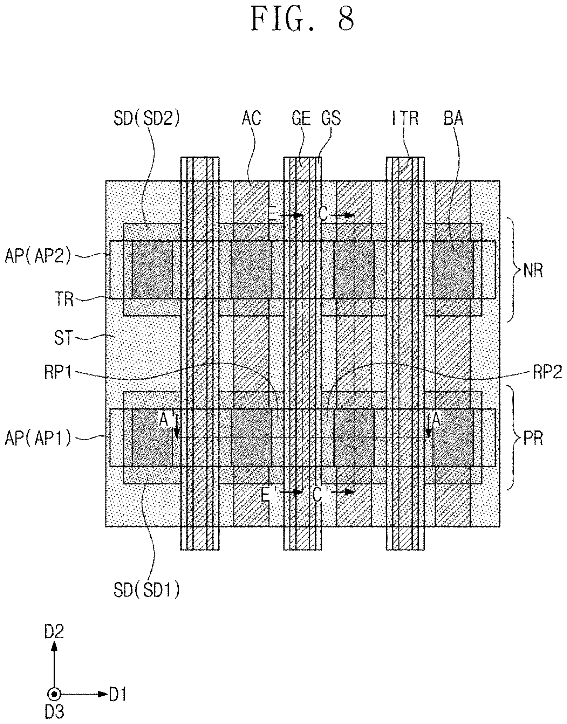

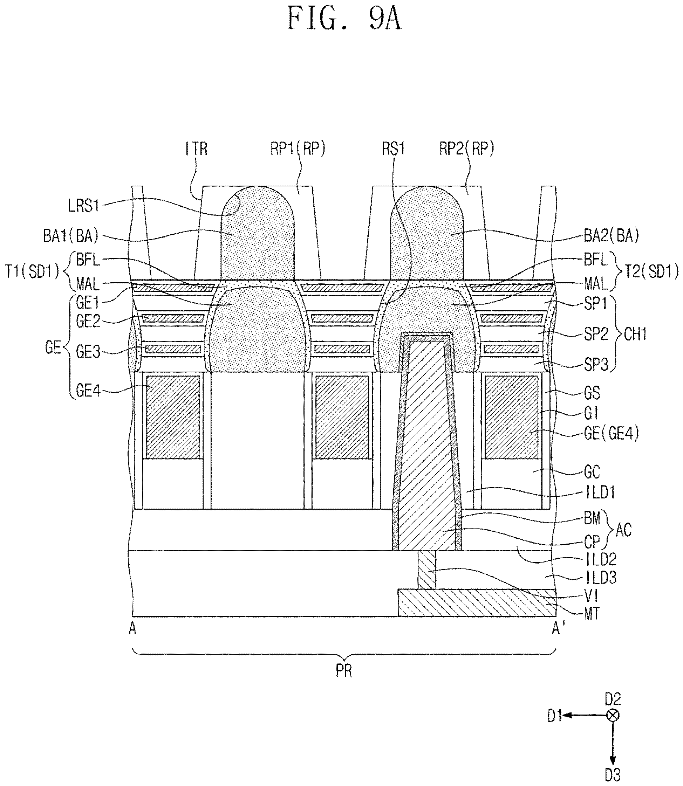

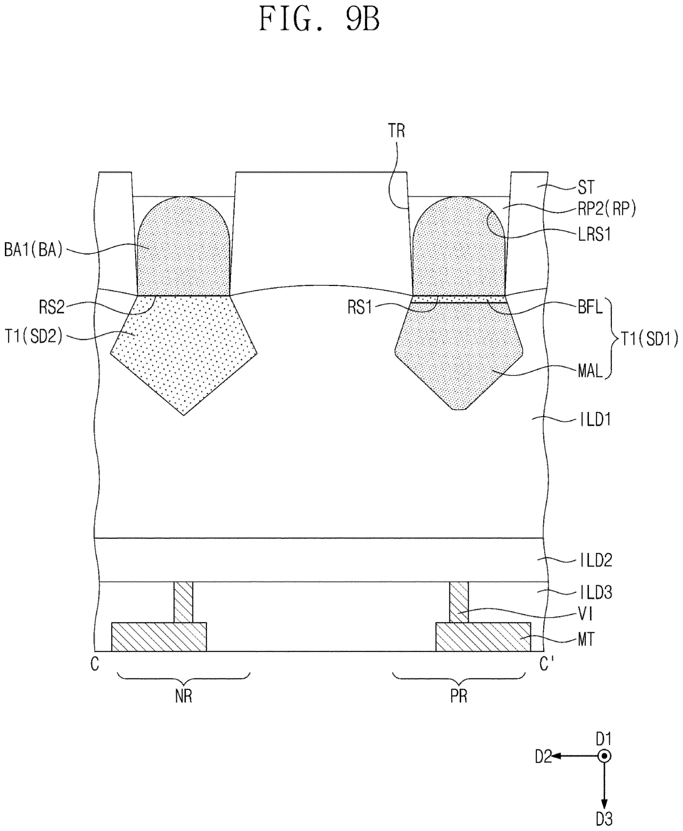

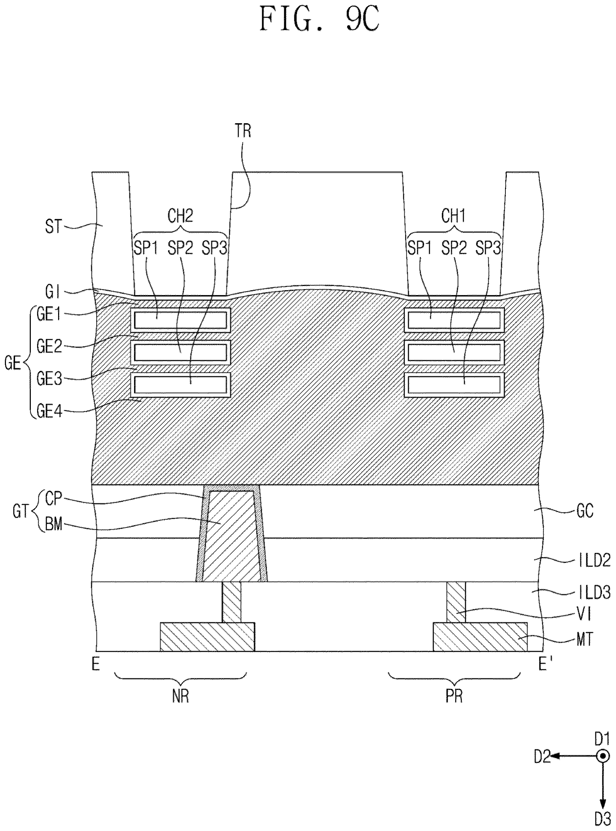

Referring to FIGS. 8 and 9A to 9C, a gate electrode GE may be formed on the gate insulating pattern GI. The gate electrode GE may include an inner electrode (e.g., first to third electrode portions GE1, GE2, and GE3) formed in each of the first to third inner regions IRG1, IRG2, and IRG3, and an outer electrode (e.g., a fourth electrode portion GE4) formed in the outer region ORG. Thereafter, a gate capping pattern GC may be formed on the fourth electrode portion GE4.

A second interlayer insulating layer ILD2 may be formed on the first interlayer insulating layer ILD1 and the gate capping pattern GC. The active contacts AC may be formed to penetrate the first and second interlayer insulating layers ILD1 and ILD2, and may be connected to the first and second source/drain patterns SD1 and SD2, respectively. The source/drain patterns SD1 and SD2 may include a first pattern T1 not connected to the active contact AC and a second pattern T2 connected to the active contact AC. The backside alignment pattern BA may include a first backside alignment pattern BA1 disposed below the first pattern T1 of the source/drain patterns SD1 and SD2 and a second backside alignment pattern BA2 disposed below the second pattern T2 of the source/drain patterns SD1 and SD2.

Gate contacts GT may be formed to penetrate the second interlayer insulating layer ILD2 and the gate capping pattern GC, and may be connected to the gate electrodes GE.

Forming the active contacts AC and the gate contacts GT may include forming a barrier pattern BM and forming a conductive pattern CP on the barrier pattern BM. An ohmic pattern OM may be formed between the active contact AC and the second pattern T2 of the source/drain patterns SD1 and SD2.

A third interlayer insulating layer ILD3 may be formed on the second interlayer insulating layer ILD2 and the active contacts AC. Metal patterns MT and vias VI may be formed in the third interlayer insulating layer ILD3.

After the back end of line (BEOL) process is completed, the semiconductor device may be inverted (e.g. flipped) so that the top and bottom of the semiconductor substrate 100 described with reference to FIGS. 4A and 4B may be reversed. When the top and bottom of the semiconductor substrate 100 (e.g., FIG. 4A) are reversed in a view from the semiconductor device completely manufactured as described with reference to FIGS. 2A to 2D, the 'upper surface' and 'upper portion' may mean the `lower surface' and `lower portion', respectively. In a view from the semiconductor device completely manufactured as described with reference to FIGS. 2A to 2D, the `lower surface' and `lower portion' may mean the 'upper surface' and 'upper portion'.

An isolation trench ITR may penetrate the semiconductor substrate 100 (e.g., FIG. 4A) and the active patterns AP1 and AP2 (e.g., FIG. 4A), and may be formed to extend in the second direction D2. For example, the isolation trench ITR may vertically overlap the gate electrode GE. In addition, the isolation trench ITR may extend in a direction in which the gate electrode GE extends. By the isolation trench ITR, the semiconductor substrate 100 (e.g., FIG. 4A) and the active patterns AP1 and AP2 (e.g., FIG. 4A) may be separated into a plurality of remaining patterns RP that are spaced apart from each other in the first direction D1.

According to embodiments of the present inventive concept, after the top and bottom of the semiconductor substrate 100 (e.g., FIG. 4A) is reversed, the isolation trench ITR may be formed to penetrate the semiconductor substrate 100 (e.g., FIG. 4A) and the active pattern AP1 and AP2 (e.g., FIG. 4A) and to extend in a direction in which the gate electrode GE extends. The isolation trench ITR may cause the semiconductor substrate 100 (e.g., FIG. 4A) and the active patterns AP1 and AP2 (e.g., FIG. 4A) to be separated into a plurality of remaining patterns RP that are spaced apart from each other in the first direction D1. The remaining patterns RP are therefore remaining portions of the semiconductor substrate 100 and the active patterns AP1 and AP2 after the isolation trench ITR is formed. As the remaining patterns RP are spaced apart from each other, leakage current due to the remaining pattern RP between the source/drain patterns SD1 and SD2 may be prevented. In the case of the present inventive concept, the leakage current may be prevented only by forming the isolation trench ITR without removing both the semiconductor substrate 100 (e.g., FIG. 4A) and the active patterns AP1 and AP2 (e.g., FIG. 4A). The present inventive concept may simplify the removal process of the semiconductor substrate 100 (e.g., FIG. 4A) and the active pattern AP1 and AP2 (e.g., FIG. 4A) and may increase productivity of the semiconductor device.

A width of the isolation trench ITR in the first direction D1 may become smaller toward the third direction D3. For example, the isolation trench ITR may have a tapered shape. A portion of the gate insulation pattern GI may be exposed by an inner surface of the isolation trench ITR. A plurality of isolation trenches ITR may be provided, and the isolation trenches ITR may be spaced apart from each other in the first direction D1. Each of the isolation trenches ITR may vertically overlap the corresponding gate electrode GE.

Thereafter, a removal process may be performed on upper portions of the remaining patterns RP, and thus, upper surfaces of the remaining patterns may be formed to be substantially coplanar with upper surfaces of the backside alignment patterns BA. As an example, the removal process may include a CMP process.

The remaining pattern RP may include a first remaining pattern RP1 and a second remaining pattern RP2. The first remaining pattern RP1 may be formed on the first backside alignment pattern BA1, and the second remaining pattern RP2 may be formed on the second backside alignment pattern BA2.

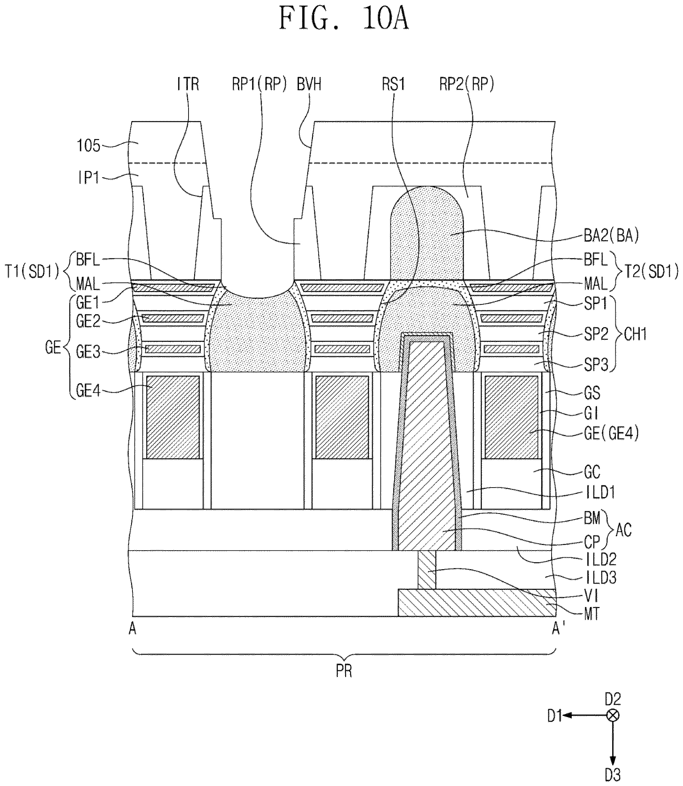

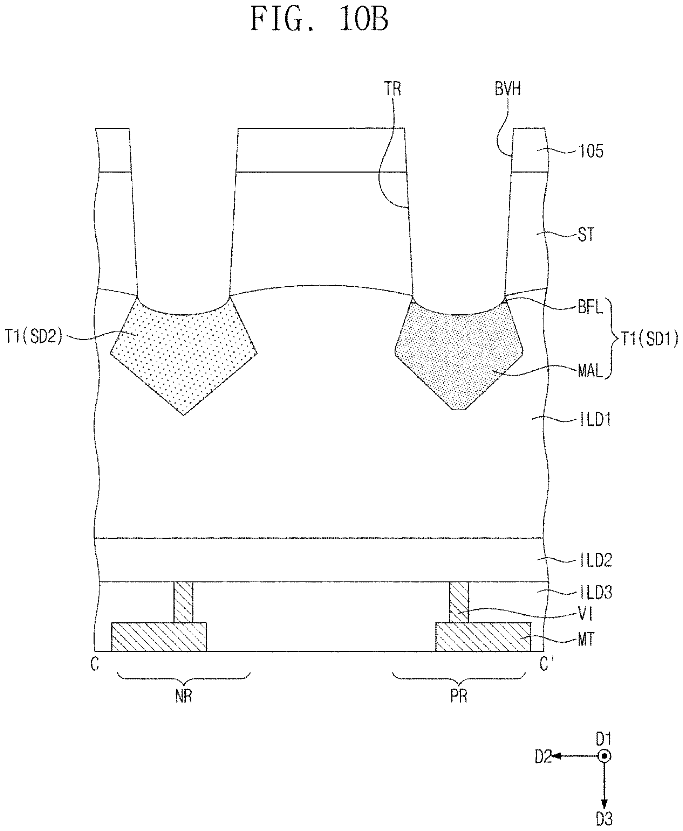

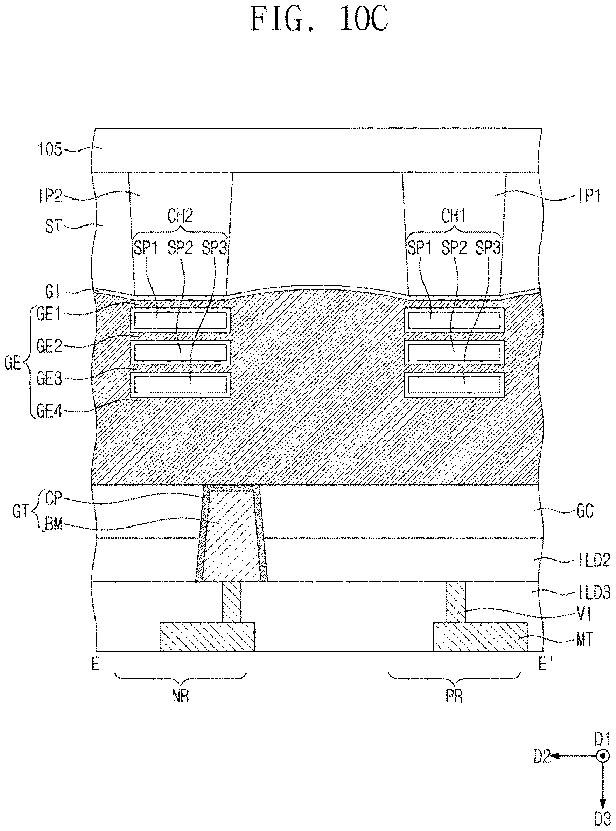

Referring to FIGS. 1 and 10A to 10C, a substrate 105 may be formed to fill a region where the upper portions of the semiconductor substrate 100 (e.g., FIG. 4A), the active patterns AP1 and AP2 (e.g., FIG. 4A), and the remaining patterns RP are removed, respectively. As an example, the substrate 105 may be formed by filling an insulating material to a level higher than the removed region of the semiconductor substrate 100 (e.g., FIG. 4A).

A backside via hole BVH may be formed to penetrate the substrate 105. At this time, the backside via hole BVH may further penetrate an upper portion of the first remaining pattern RP1 and an upper of the first backside alignment pattern BA1. Accordingly, the first backside alignment pattern BA1 may be exposed on an inner surface of the backside via hole BVH. Thereafter, the exposed first backside alignment pattern BA1 may be removed.

Referring again to FIGS. 1 and 2A to 2D, a backside conductive structure BCS may be formed to fill an interior of the backside via hole BVH. Forming the backside conductive structure BCS may include forming a backside surface barrier pattern BBM that conformally covers each of an inner wall and an inner surface of the backside via hole BVH, and filling the interior of the backside via hole BVH on the backside barrier pattern BBM to form a back conductive pattern BT. As an example, the backside conductive pattern BT may be formed through a single process, and accordingly, a separate interface might not be formed in the backside conductive pattern BT. As a result, electrical resistance of the backside conductive pattern BT may be relatively smaller, thereby improving electrical characteristics of the semiconductor device.

In the first direction D1, depending on the formed width of the backside via hole BVH described with reference to FIGS. 1 and 10A to 10C, the backside conductive structure BCS illustrated with reference to FIGS. 2A to 2D may be formed, or the backside conductive structure BCS described with reference to FIG. 3 may be formed.

Thereafter, a power distribution network layer PDN may be formed on a lower surface of the substrate 105.

According to embodiments of the present inventive concept, after the BEOL process is completed and the top and bottom of the semiconductor substrate is reversed, the isolation trench that penetrates the semiconductor substrate and the active pattern and extends in the direction in which the gate electrode extends may be formed. The semiconductor substrate and the active pattern may be separated into a plurality of remaining patterns that are spaced apart from each other in the first direction by the isolation trench. As the remaining patterns are spaced apart from each other, the leakage current due to the remaining patterns between the source/drain patterns may be prevented. According to embodiments of the present inventive concept, the leakage current may be prevented simply by forming an isolation trench without removing the semiconductor substrate and the active pattern. Embodiments of the present inventive concept may simplify the removal process of the semiconductor substrate and active pattern, and may improve the productivity of the semiconductor device.

Embodiments are set out in the following Clauses:
Clause 1. A semiconductor device comprising:
   a substrate:
   a power distribution network layer on a lower surface of the substrate;
   a source/drain pattern on the substrate;
   a backside conductive structure configured to penetrate the substrate and to electrically connect the source/drain pattern and the power distribution network layer to each other; and
   a remaining pattern on a side surface of the backside conductive structure,
   wherein the backside conductive structure has a step at the first level, and
   wherein a lower surface of the remaining pattern is positioned at a level substantially the same as or lower than the first level.
Clause 2. The semiconductor device of Clause 1, wherein the remaining pattern includes silicon (Si).
Clause 3. The semiconductor device of Clause 1 or Clause 2, wherein a level of the lower surface of the remaining pattern is substantially the same.
Clause 4. The semiconductor device of any preceding Clause, wherein the lower surface of the remaining pattern extends on the side surface of the backside conductive structure in a direction parallel to the lower surface of the substrate.
Clause 5. The semiconductor device of any preceding Clause, wherein the remaining pattern is a first remaining pattern,
   wherein the source/drain pattern is a first pattern of the source/drain pattern,
   wherein the semiconductor further includes a second source/drain pattern adjacent to the first pattern,
   wherein the semiconductor further includes a backside alignment pattern below the second pattern and a second remaining pattern on a side surface of the backside alignment pattern, and
   wherein the first remaining pattern and the second remaining pattern are spaced apart from each other.
Clause 6. A semiconductor device comprising:
   a substrate:
   a power distribution network layer on a lower surface of the substrate;
   an insulating pattern on the substrate;
   a source/drain pattern on the insulating pattern;
   a channel pattern on a side surface of the source/drain pattern, the channel pattern including a plurality of semiconductor patterns stacked and spaced apart from each other;
   a gate electrode between the plurality of semiconductor patterns;
   a backside conductive structure configured to penetrate the substrate and to electrically connect the source/drain pattern and the power distribution network layer to each other; and
   a remaining pattern on a side surface of the backside conductive structure,
   wherein the backside conductive structure has a step at the first level, and
   wherein a lower surface of the remaining pattern is positioned at a level substantially the same as or lower than the first level.
Clause 7. The semiconductor device of Clause 6, wherein the remaining pattern includes silicon (Si).
Clause 8. The semiconductor device of Clause 6 or Clause 7, wherein the lower surface of the remaining pattern extends on the side surface of the backside conductive structure in a direction parallel to the lower surface of the substrate.

While the present inventive concept has been described with reference to embodiments thereof, it will be understood by those of ordinary skill in the art that various changes in form and details may be made thereto without departing from the spirit and scope of the present inventive concept.

## Claims

1. A semiconductor device comprising:
a sub state;
a power distribution network layer disposed on a lower surface of the substrate;
a source/drain pattern disposed on the substrate;
a backside conductive structure configured to penetrate the substrate and to electrically connect the source/drain pattern and the power distribution network layer to each other; and
a remaining pattern covering a side surface of an upper portion of the backside conductive structure.

2. The semiconductor device of claim 1, wherein the remaining pattern includes silicon.

3. The semiconductor device of claim 1 or claim 2, wherein a level of a lower surface of the remaining pattern is substantially constant.

4. The semiconductor device of any preceding claim, wherein a lower surface of the remaining pattern extends on a side surface of the backside conductive structure in a direction parallel to the lower surface of the substrate.

5. The semiconductor device of any preceding claim, wherein a lower surface and a side surface of the remaining pattern meet each other to form an angle of 90 degrees or more, and
wherein the side surface of the remaining pattern is opposite to the side surface of the upper portion of the backside conductive structure.

6. The semiconductor device of any preceding claim, wherein the remaining pattern covers at least part of a side surface of a lower portion of the backside conductive structure.

7. The semiconductor device of any preceding claim, wherein the backside conductive structure has a step at a first level, and
wherein a lower surface of the remaining pattern is positioned at a level substantially the same as or lower than the first level.

8. The semiconductor device of any preceding claim, wherein the remaining pattern is a first remaining pattern,
wherein the source/drain pattern is a first source/drain pattern,
wherein the semiconductor device further includes a second source/drain pattern adjacent to the first source/drain pattern, and
wherein the semiconductor device further includes a backside alignment pattern and a second remaining pattern, wherein the backside alignment pattern is disposed below the second source/drain pattern, and the second remaining pattern covers a side surface of the backside alignment pattern.

9. The semiconductor device of claim 8, wherein the first remaining pattern and the second remaining pattern are spaced apart from each other.

10. The semiconductor device of claim 8 or claim 9, further comprising a gate electrode disposed on the substrate,
wherein a side surface of the first remaining pattern and a side surface of the second remaining pattern, which faces the side surface of the first remaining pattern, vertically overlap the gate electrode.

11. The semiconductor device of any of claims 8-10, wherein a distance between the first remaining pattern and the second remaining pattern becomes smaller as the first remaining pattern and the second remaining pattern extend in a direction perpendicular to the lower surface of the substrate.

12. The semiconductor device of any of claims 8-11, wherein a lower surface of the second remaining pattern is positioned at a level substantially equal to or lower than a lower surface of the backside alignment pattern.
